Europäisches Patentamt

European Patent Office

Office européen des brevets

(11) Publication number: **0 281 710 B1**

# EUROPEAN PATENT SPECIFICATION

(45) Date of publication of patent specification: **13.05.92**   (51) Int. Cl.⁵: **H01M 2/10**

(21) Application number: **87310733.8**

(22) Date of filing: **07.12.87**

(54) **Sealed-battery arrangement.**

(30) Priority: **12.05.87 JP 115627/87**
**12.03.87 JP 36388/87**
**12.05.87 JP 70597/87**

(43) Date of publication of application:
**14.09.88 Bulletin 88/37**

(45) Publication of the grant of the patent:
**13.05.92 Bulletin 92/20**

(84) Designated Contracting States:
**BE CH DE ES GB IT LI LU NL**

(56) References cited:
**DE-C- 19 161**         **FR-A- 874 287**
**GB-A- 170 701**        **US-A- 1 494 397**
**US-A- 3 051 831**      **US-A- 4 258 967**

(73) Proprietor: **YUASA BATTERY CO., LTD.**
**6-6, Johsai-cho**
**Takatsuki-shi, Osaka(JP)**

(72) Inventor: **Kasai, Yoshio**
**6-6, Johsai-cho**
**Takatsuki City Osaka Pref.(JP)**

(74) Representative: **Bannerman, David Gardner et al**
**Withers & Rogers 9 The Parade**
**Leamington Spa Warwickshire CV32 5DG(GB)**

## Description

This invention relates to a sealed-battery arrangement more particularly, such an arrangement that includes a plurality of sealed-battery units disposed on a rack to serve as a battery set.

When sealed-battery units in a set contain a non-solid electrolyte, the units have to be arranged upright. However, with more modern, and increasingly popular, leak-proof battery units it has been proposed to lay the units on their sides with their terminals facing forwards (as shown in Figure 6) so facilitating handling of, and connections between, the terminals thereof.

This has the disadvantage that various fixtures and fittings are needed including bottom frames 3a' for supporting the bottom of the battery units, side frames 3b' for supporting the upper side surfaces thereof and frames 9 designed to insulate each battery units from vibration. Also, a battery unit on the lowermost frame is difficult to handle; and further, there is a risk of accident due to any uneven distribution of the electrolyte or a bending load applied to the electrolytic cell.

One object of the present invention is to eliminate the above-described disadvantages of conventional battery arrangements and the main object of this invention is to provide a sealed-battery arrangement which requires a comparatively small amount of materials for the placement of battery units, is easy to handle and has an excellent vibration-proof property.

The sealed-battery arrangement according to this invention has a structure such that a plurality of sealed-battery units are placed on supports attached to columns of a rack at a desired angle of inclination.

Embodiments of this invention will now be described by way of example with reference to the accompanying drawings, in which:

Figures 1 to 5 (a and b) are views illustrating different sealed-battery arrangements according to this invention; and

Figure 6 shows a conventional battery arrangement.

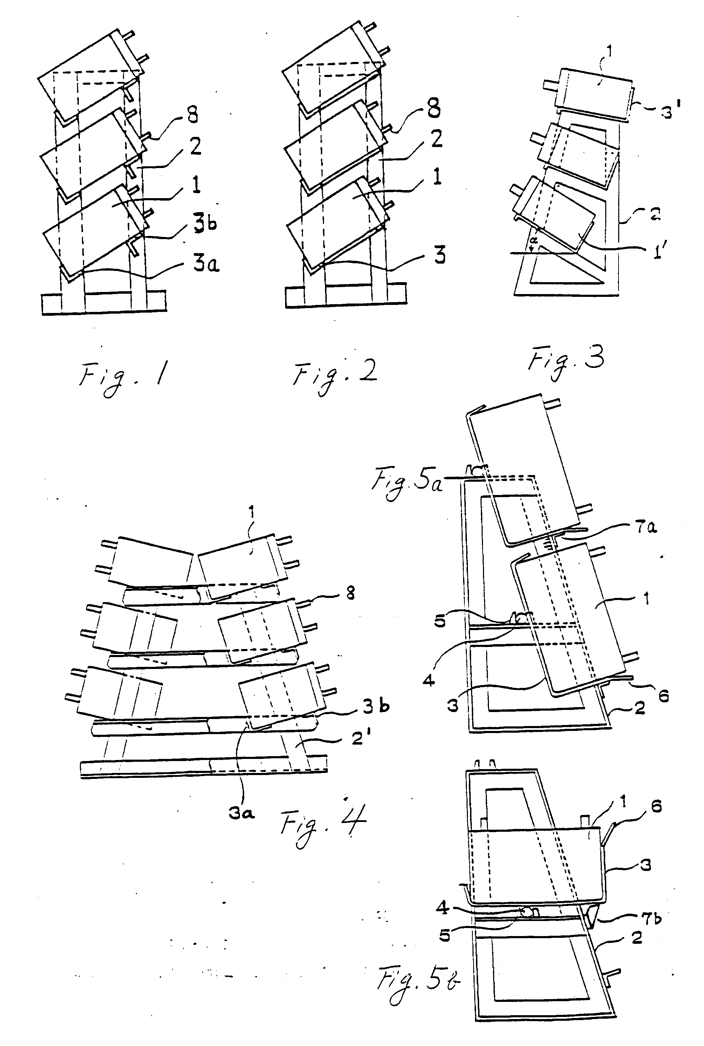

Figure 1 shows a set of three sealed-battery units 1, arranged on a rack comprising a pair or upright columns 2 interconnected by cross-beams. Base supports 3a and side supports 3b each comprise an L-shaped or angle section and in each pair of base (3a) and side (3b) supports, the side support 3b is attached to one of the columns 2 at a position higher than the bottom support 3a which is attached to the other column. Hence, a sealed-battery unit 1 can be arranged on supports 3a and 3b as shown in Figure 1 with its terminals 8 directing upwardly at a certain angle of inclination.

In the embodiment of Figure 2, L-shaped supports perform the function of both of the supports 3a and 3b in Figure 1 and each is attached aslant across the pair of upright columns 2 providing an inclined support for unit 1.

Similar L-shaped supports 3' are used also in the embodiments of Figure 3 but these are attached across the columns 2 at different angles and preferably, as shown, such that the angle between the supports 3' and the horizontal gradually decreases from the lowermost to the uppermost support. This facilitates handling of a battery unit 1' placed on the lowermost support.

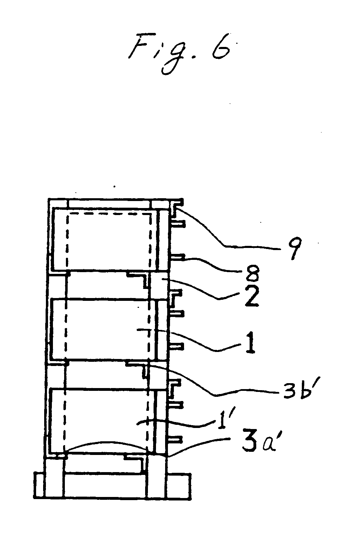

A fourth embodiment shown in Figure 4 includes base supports 3a and side supports 3b similar to those of the embodiment of Figure 1, attached to both sides, respectively, of each of a pair of inclined columns 2' of a trapezoidal rack so that the battery units can be supported at the desired angle, on the supports 3a and 3b of each of the columns with the base of each battery unit on one of the columns being opposite to that of a battery unit on the other column.

It should be noted that although the columns 2 to which the supports 3, 3a and 3b are attached are upright in Figure 1 and 2, they may in inclined to form a trapezoidal rack having a larger and, hence, more stable base.

Equally, the columns in the embodiments of Figures 3 and 4 may be upright. When selecting any of the various possible embodiments for use consideration should be given to the vibration-resistance required and the floor area available.

Figures 5a and 5b show a further embodiment wherein each support 3 is fixed to a rotatable shaft 4 engaging bearing means 5 on each of crossbeams connecting the columns 2 so that the support 3 can be tilted from a horizontal battery unit loading position shown in Figure 5b to an inclined position as shown in Figure 5a. The rotary shaft 4 may be made to engage the bearing means 5 at a position rearward of the centre of the support 3 so that when the battery unit 1 is loaded on the support 3, the support 3 needs to be held horizontal e.g by lifting means (not shown) engageable with a hook 6 attached to the support, but will tilt downwardly under its own weight and the weight of the battery unit to be supported at a desired angle of inclination by an abutment 7a on one of the columns 2. In the absence of a lifting means such as a hoist, an abutment 7b attached to one of the columns 2 may be provided to hold the support 3 horizontally. Moreover, if the supports are attached at an angle of inclination of 10 - 20 degrees with respect to the horizontal, the battery unit will not fall when the arrangement is subject to vibration.

The sealed-battery arrangement yields various advantages since each of the battery units can be placed on the support or supports with its terminal directed upwardly at the desired angle of inclination, the inter-connection of terminals and the measurement of voltage across the terminals can be facilitated; uneven distribution of electrolyte and the bending load applied to the battery unit is reduced as compared with arrangements in which battery unit is placed to lie horizontally on their side, so that the risk of accidents is far less. Further, the use of a trapezoidal rack enables improved stability and vibration resistance of the arrangement.

**Claims**

1. A sealed-battery arrangement comprising a rack including at least two columns (2, 2') interconnected by cross beams and supports (3, 3', 3a, 3b) mounted on the rack supporting a plurality of sealed-battery units (1) wherein each support is shaped and oriented so as to engage the base and/or one side of a battery unit with the terminals (8) of each battery unit (1) directed upwardly at a predetermined angle ($\alpha$) of inclination to the horizontal.

2. A sealed-battery arrangement according to claim 1 wherein the supports (3a, 3b) are arranged in pairs, each battery unit (1) being supported by one pair of supports.

3. A sealed-battery arrangement according to claim 1 or claim 2 wherein the plurality of supports (3a, 3b) are arranged at different levels to support battery units (1) at different angles ($\alpha$) of inclination, wherein the angle of inclination decreases from the lowermost level frame toward the uppermost level.

4. A sealed-battery arrangement according to any one of claims 1 to 3 wherein the columns (2) of the rack are upright.

5. A sealed-battery arrangement according to any one of claims 1 to 3 wherein the rack is in the form of a trapezoid so as to provide a large floor area for said plurality of battery units.

6. A sealed-battery arrangement according to any one of claims 1 to 5 wherein the supports (3a, 3b) are attached to each of said columns of said rack so that when said battery units (1) are placed on their respective supports, the base of each of the battery units on one of the columns is opposite to the base of a battery unit on the other columns.

7. A sealed-battery arrangement according to any of claims 1 to 6 wherein each support (3) is rotatable, between a loading position wherein the battery unit (1) is held horizontal and an in-use position wherein the battery unit is supported at the said predetermined angle of inclination.

8. A sealed-battery arrangement according to claim 7 wherein each support (3) is affixed to a shaft (4) disposed off-centre of the support and engaging bearing means (5) on one of the cross-beams of the rack such that the support (3) is rotatable downwardly under its own weight from the loading position.

9. A sealed-battery arrangement according to claim 7 or claim 8 wherein each support (3) is rotatable downwardly into engagement with an abutment or stop (7a) defining the in-use position.

10. A sealed-battery arrangement according to any one of claims 7 to 9 wherein a hook (6) is attached to each support (3) to enable the support to be held horizontal in the loading position.

11. A sealed-battery arrangement according to any one of claims 7 to 9 wherein each support (3) is held horizontal by means of a horizontal frame support (7b) attached to one of the columns of the rack.

**Revendications**

1. Agencement de batteries étanches comprenant un bâti constitué par au moins deux montants (2, 2') reliés entre eux par des traverses et des supports (3, 3', 3a, 3b) montés sur le bâti supportant plusieurs batteries étanches (1), dans lequel chaque support a une configuration et une orientation lui permettant de coopérer avec l'embase et/ou un côté d'une batterie avec les bornes (8) de chaque batterie (1) dirigées vers le haut selon un angle d'inclinaison prédéterminé ($\alpha$) par rapport à l'horizontale.

2. Agencement de batteries étanches selon la revendication 1, dans lequel les supports (3a, 3b) sont disposés par paires, chaque batterie (1) étant supportée par une paire de supports.

3. Agencement de batteries étanches selon la revendication 1 ou la revendication 2, dans lequel plusieurs supports (3a, 3b) sont disposés à différents niveaux pour supporter les batteries (1) selon différents angles d'inclinaison (α), dans lequel l'angle d'inclinaison va en diminuant à partir du niveau le plus bas vers le niveau le plus haut.

4. Agencement de batteries étanches selon l'une quelconque des revendications 1 à 3, dans lequel les montants (2) du bâti sont verticaux.

5. Agencement de batteries étanches selon l'une quelconque des revendications 1 à 3, dans lequel le bâti est sous la forme d'un trapèze de façon à fournir une grande surface au sol pour la pluralité de batteries.

6. Agencement de batteries étanches selon l'une quelconque des revendications 1 à 5, dans lequel les supports (3a, 3b) sont fixés sur chacun des montants du bâti de sorte que lorsque les batteries (1) sont placées sur leur support respectif, l'embase de chacune des batteries sur l'un des montants est opposée à l'embase d'une batterie sur les autres montants.

7. Agencement de batteries étanches selon l'une quelconque des revendications 1 à 6, dans lequel chaque support (3) est rotatif, entre une position de chargement dans laquelle la batterie (1) est maintenue en position horizontale et une position en service dans laquelle la batterie est supportée selon un angle d'inclinaison prédéterminé.

8. Agencement de batteries étanches selon la revendication 7 dans lequel chaque support (3) est fixé sur un arbre (4) disposé de façon excentrée par rapport au support et venant en contact avec des moyens de palier (5) sur l'une des traverses du bâti de sorte que le support (3) est rotatif vers le bas sous l'effet de son propre poids à partir de la position de chargement.

9. Agencement de batteries étanches selon la revendication 7 ou la revendication 8, dans laquelle chaque support (3) est rotatif vers le bas pour venir en contact avec une butée (7a) définissant la position en service.

10. Agencement de batteries étanches selon l'une quelconque des revendications 7 à 9, dans lequel un crochet (7) est fixé sur chaque support pour permettre le maintien du support horizontalement dans la position de chargement.

11. Agencement de batteries étanches selon l'une quelconque des revendications 7 à 9, dans lequel chaque support (3) est maintenu horizontalement au moyen d'un support de châssis horizontal (7b) fixé sur l'un des montants du bâti.

**Patentansprüche**

1. Anordnung von dicht verschlossenen Batterien, welche ein Gestell aufweist, welches wenigstens zwei Stützen (2, 2') umfaßt, die über Querträger und Träger (3, 3', 3a, 3b) untereinander verbunden sind, welche an dem Gestell angebracht sind und eine Mehrzahl von dicht verschlossenen Batterieeinheiten (1) tragen, bei welcher jeder Träger derart ausgebildet und ausgerichtet ist, daß er mit der Basis und/oder einer Seite einer Batterieeinheit zusammenarbeitet, wobei die Anschlüsse (8) jeder Batterieeinheit (1) nach oben unter einem vorbestimmten Neigungswinkel (α) zur Horizontalen weisen.

2. Anordnung von dicht verschlossenen Batterien nach Anspruch 1, bei der die Träger (3a, 3b) paarweise angeordnett sind und jede Batterieeinheit (1) von einem Paar von Trägern getragen wird.

3. Anordnung von dicht verschlossenen Batterien nach Anspruch 1 oder Anspruch 2, bei der die Mehrzahl von Trägern (3a, 3b) in unterschiedlichen Höhen angeordnet ist, um die Batterieeinheiten (1) in unterschiedlichen Neigungswinkeln (α) zu halten, und bei der der Neigungswinkel von der tiefstliegenden Stelle im Gestell zu der höchsten Stelle abnimmt.

4. Anordnung von dicht verschlossenen Batterien nach einem der Ansprüche 1 bis 3, bei der die Stützen (2) des Gestells senkrecht stehend angeordnet sind.

5. Anordnung von dicht verschlossenen Batterien nach einem der Ansprüche 1 bis 3, bei der das Gestell in Form eines Trapezes derart ausgelegt ist, daß ein großer Bodenbereich für die Mehrzahl von Batterieeinheiten bereitgestellt wird.

6. Anordnung von dicht verschlossenen Batterien nach einem der Ansprüche 1 bis 5, bei der die Träger (3a, 3b) an der jeweiligen Stütze des Gestells derart angebracht sind, daß, wenn die Batterieeinheiten (1) auf die jeweiligen Träger gelegt sind, die Basis jeder Batterieeinheit auf einer der Stützen entgegengesetzt zu der Basis einer Batterieeinheit auf der jeweils anderen Stütze gerichtet ist.

7. Anordnung von dicht verschlossenen Batterien nach einem der Ansprüche 1 bis 6, bei der jeder Träger (3) zwischen einer Aufgabeposition, in welcher die Batterieeinheit (1) horizontal gehalten ist, und einer Gebrauchsposition drehbar ist, in welcher die Batterieeinheit unter dem vorbestimmten Neigungswinkel gehalten ist.

8. Anordnung von dicht verschlossenen Batterien nach Anspruch 7, bei der jeder Träger (3) fest mit einer Achse (4) verbunden ist, welche außermittig von dem Träger angeordnet ist und mit Lagereinrichtungen (5) an einem der Querträger des Gestells derart zusammenarbeitet, daß der Träger (3) unter seinem Eigengewicht aus der Aufgabeposition nach unten verdrehbar ist.

9. Anordnung von dicht verschlossenen Batterien nach Anspruch 7 oder Anspruch 8, bei der jeder Träger (3) zum Zusammenarbeiten mit einem Widerlager oder einem Anschlag (7a) nach unten drehbar ist, welcher die Gebrauchsposition bestimmt.

10. Anordnung von dicht verschlossenen Batterien nach einem der Ansprüche 7 bis 9, bei der ein Haken (6) am jeweiligen Träger (3) angebracht ist, um zu ermöglichen, daß der Träger horizontal in der Aufgabeposition gehalten ist.

11. Anordnung von dicht verschlossenen Batterien nach einem der Ansprüche 7 bis 9, bei der jeder Träger (3) mit Hilfe eines horizontalen Rahmenträgers (7b) horizontal gehalten ist, welcher an einer der Stützen des Gestells angebracht ist.

Fig. 1

Fig. 2

Fig. 3

Fig. 4

Fig. 5a

Fig. 5b

Fig. 6